(19) Europäisches Patentamt
European Patent Office
Office européen des brevets

(11) **EP 2 256 921 B1**

(12) **FASCICULE DE BREVET EUROPEEN**

(45) Date de publication et mention
de la délivrance du brevet:
**29.11.2017 Bulletin 2017/48**

(51) Int Cl.:
*H03B 5/30* (2006.01)          *H03H 9/00* (2006.01)
*H03H 9/46* (2006.01)

(21) Numéro de dépôt: **10154724.8**

(22) Date de dépôt: **25.02.2010**

(54) **Dispositif résonant micrométrique ou nanométrique à transistors**

Mikrometrisch oder nanometrisch Resonanzgerät mit Transistoren ausgestattet.

Micrometric or nanometric resonating device using transistors.

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **27.02.2009 FR 0900903**

(43) Date de publication de la demande:
**01.12.2010 Bulletin 2010/48**

(73) Titulaire: **Commissariat à l'Énergie Atomique et aux Énergies Alternatives**
**75015 Paris (FR)**

(72) Inventeurs:
• **Duraffourg, Laurent**
**38500 Voiron (FR)**
• **Andreucci, Philippe**
**38430 Moirans (FR)**
• **Colinet, Eric**
**38240 Meylan (FR)**
• **Hentz, Sébastien**
**38000 Grenoble (FR)**
• **Ollier, Eric**
**38100 Grenoble (FR)**

(74) Mandataire: **de Jong, Jean Jacques et al**
**Cabinet Hecké**
**10, rue d'Arménie**
**Europole**
**BP 1537**
**38025 Grenoble Cedex 1 (FR)**

(56) Documents cités:
FR-A- 2 316 786          US-A- 3 054 973
US-B1- 6 448 103

• VERD J ET AL: "Monolithic CMOS MEMS Oscillator Circuit for Sensing in the Attogram Range" IEEE ELECTRON DEVICE LETTERS, IEEE SERVICE CENTER, NEW YORK, NY, US, vol. 29, no. 2, 1 février 2008 (2008-02-01), pages 146-148, XP011200397 ISSN: 0741-3106
• MATTILA T ET AL: "14 MHz micromechanical oscillator" 1 avril 2002 (2002-04-01), SENSORS AND ACTUATORS A, ELSEVIER SEQUOIA S.A., LAUSANNE, CH, PAGE(S) 497 - 502 , XP004361643 ISSN: 0924-4247 * le document en entier *

EP 2 256 921 B1

## Description

### Domaine technique de l'invention

L'invention est relative à un dispositif résonant comportant un résonateur électromécanique de taille nanométrique ou micrométrique, comportant un élément mobile et un élément fixe, des moyens de détection fournissant des signaux de détection, représentatifs d'un mouvement de l'élément mobile par rapport à l'élément fixe, à une boucle de réaction connectée à une entrée d'excitation du résonateur.

### État de la technique

Afin de pourvoir continuer la course à la miniaturisation, les circuits intégrés doivent intégrer de nouvelles fonctions et doivent faire fonctionner ces nouvelles fonctions à des échelles toujours plus petites. Un des principaux domaines d'étude est l'intégration de dispositifs résonants à l'intérieur des puces. En effet, dans de nombreux domaines, tels que les capteurs chimiques en phase gazeuse, les capteurs de force moléculaire ou encore les spectromètres de masse, il est intéressant que le circuit intégré comporte au moins un résonateur. Les concepteurs travaillent à remplacer le résonateur qui est un composant discret par un résonateur intégré. En intégrant ce résonateur, on peut alors espérer, en plus du gain en surface ou en volume du dispositif, un gain en énergie consommée et une amélioration des performances pour former, par exemple un oscillateur intégré.

Le résonateur peut être, par exemple, un résonateur électromécanique, avantageusement de taille micrométrique ou nanométrique, par exemple présentant un élément mobile de type poutre, plaque, disque ou nanofil, ou un résonateur électrique qui peut être assimilé à un circuit passif de type RLC. Le résonateur comporte une entrée d'excitation qui agit sur les moyens d'excitation.

De nombreuses publications traitent de résonateurs électromécaniques de taille micrométrique ou nanométrique, c'est-à-dire des résonateurs ayant des dimensions compatibles avec celles des circuits intégrés. Cependant, si l'obtention du résonateur à une taille raisonnable est un point important, il est nécessaire que la partie électronique qui lui est associée, afin de transformer un résonateur en un oscillateur, soit également compatible avec le cahier des charges très strict du circuit intégré.

Des oscillateurs utilisant un résonateur électromécanique de taille micrométrique ou nanométrique ont déjà été démontrés, mais ces résonateurs occupent une place très importante, typiquement une surface de l'ordre de $100*100\mu m^2$. De ce fait, les résonateurs ne peuvent pas être intégrés sur un circuit intégré. En effet, la plupart des résonateurs de taille micrométrique comporte un circuit électronique déporté, c'est-à-dire un circuit électronique qui n'est pas réalisé sur le même substrat que le résonateur. Il est alors nécessaire d'assembler, par des procédés complexes, le résonateur à son circuit de fonctionnement.

Un article de Feng et al. « A self-sustaining ultrahigh-frequency nanoelectromechanical oscillator » nature nanotechnology, vol. 3, juin 2008, décrit un oscillateur qui comporte un résonateur électromécanique de taille nanométrique associé à un circuit de contre-réaction complexe. Il en est de même de l'oscillateur présenté par Verd et al. « Monolithic CMOS MEMS Oscillator Circuit for Sensing in the Attogram Range », IEEE Electron Device Letters , Vol. 29, N°2, February 2008.

### Objet de l'invention

L'objet de l'invention consiste à réaliser un dispositif résonnant, par exemple de type oscillateur, qui soit facile à mettre en oeuvre et qui occupe une surface très faible.

Le dispositif selon l'invention est caractérisé par les revendications annexées et plus particulièrement par le fait que le résonateur étant formé sur un même substrat que les moyens de détection et la boucle de réaction, la boucle de réaction comporte au plus un premier et un second transistors connectés en série entre une tension de référence et l'entrée d'excitation, une charge capacitive étant connectée entre l'entrée d'excitation et la tension de référence, les signaux de détection contrôlant la conductivité dudit premier transistor.

### Description sommaire des dessins

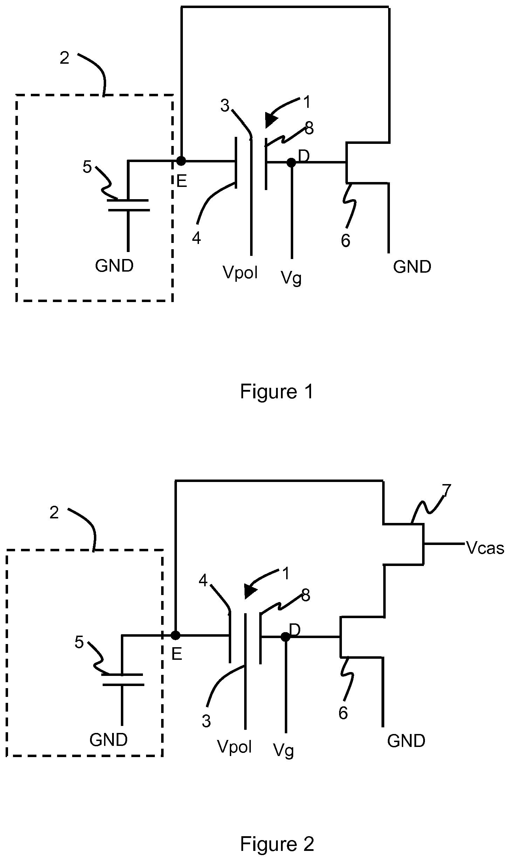

D'autres avantages et caractéristiques ressortiront plus clairement de la description qui va suivre de modes particuliers de réalisation de l'invention donnés à titre d'exemples non limitatifs et représentés aux dessins annexés, dans lesquels les figures 1 à 10 représentent différents modes de réalisation particuliers d'un oscillateur.

### Description de modes de réalisation préférentiels de l'invention

La figure 1 illustre un exemple de dispositif résonant forme un oscillateur qui comporte un résonateur électromécanique 1 de taille micrométrique ou nanométrique et son circuit d'oscillation associé. Le dispositif résonant est connecté à un élément de polarisation 2. Le résonateur 1 comporte un élément mobile 3 et au moins un élément fixe 4. L'élément mobile 3 peut osciller par rapport à l'élément fixe 4. L'élément fixe 4 représente au moins les moyens d'excitation de l'élément mobile 3 du résonateur 1. Ainsi, on considère que les moyens d'excitation font partie intégrante du résonateur 1. De ce fait, le résonateur 1 comporte une borne d'excitation E qui contrôle la force d'excitation émise par l'élément fixe 4, également appelée électrode d'excitation.

Les moyens d'excitation sont avantageusement de type capacitif ou de type thermoélastique, mais ils peuvent également être d'un autre type adapté à l'actionnement de l'élément mobile 3.

Le dispositif résonant comporte également des moyens de détection du mouvement de l'élément mobile 3 par rapport à l'élément fixe 4. Les moyens de détections convertissent le mouvement de l'élément mobile 3 en un signal électrique qui est alors un signal représentatif de la position de l'élément mobile 3 par rapport à l'élément fixe 4. De ce fait le résonateur comporte une borne D à partir de laquelle le signal représentatif du mouvement de l'élément mobile 3 est transmis vers l'extérieur et donc vers la boucle de réaction.

Les moyens de détections sont avantageusement de type capacitif ou de type piézorésistif, mais ils peuvent également être d'un autre type adapté à la mesure de la position de l'élément mobile 3.

Dans le mode de réalisation particulier, illustré à la figure 1, il est possible d'utiliser un résonateur 1 qui possède un élément fixe additionnel 8. Cet élément fixe additionnel 8 peut être associé à une borne d'excitation supplémentaire. L'élément fixe additionnel est une électrode de détection permettant de mieux découpler les signaux d'excitation et de détection. Une tension de polarisation Vg est alors appliquée sur l'élément fixe additionnel 8 afin de mieux contrôler les caractéristiques du résonateur 1. La tension de polarisation Vg permet de contrôler le point de fonctionnement du premier transistor 6. L'électrode d'excitation supplémentaire n'est utilisable que pour une excitation de type capacitive.

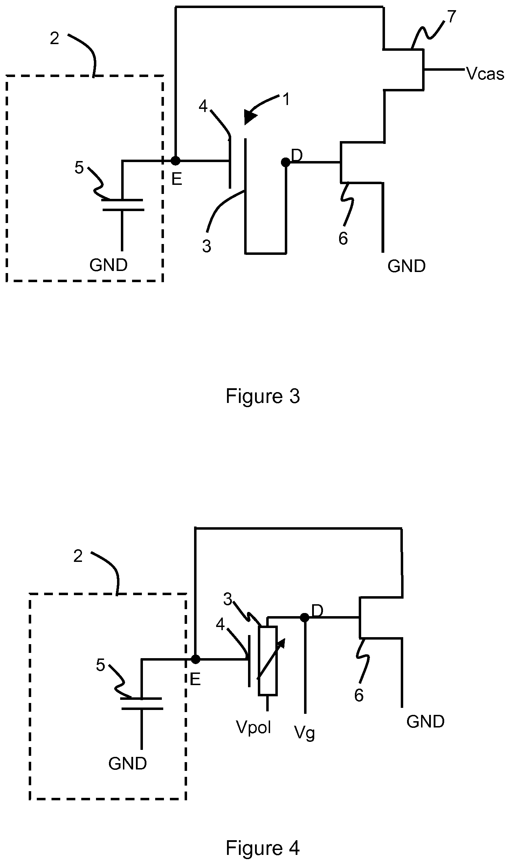

Les moyens de détection du mouvement de l'élément mobile peuvent être réalisés par l'élément fixe additionnel 8 (figures 1 et 3) ou dans un autre mode de réalisation, l'élément mobile 3 peut comporter ou constituer les moyens de détections (figures 3, 4, 5).

Afin de former un oscillateur, le signal représentatif du mouvement de l'élément mobile 3 du résonateur 1 doit être transformé, en général amplifié et déphasé, de manière à ce que les conditions d'oscillations soient remplies. Le signal représentatif transformé est alors réinjecté dans le résonateur 1 par l'intermédiaire des moyens d'excitation, c'est-à-dire par sa borne d'excitation E.

La transformation du signal est réalisée dans une boucle de réaction qui connecte les moyens de détection à la borne d'excitation E et par le fait que l'élément de polarisation 2 comporte au moins une charge 5 capacitive, ici un condensateur. La charge 5 capacitive est connectée entre la borne d'excitation (E) et la tension de référence (GND). Le signal en courant, issu du résonateur 1 par les moyens de détection, est amplifié et/ou transformé en tension et déphasé de 90° ou $\pi/2$ au moyen de l'élément de polarisation 2 capacitif.

Ainsi, les moyens de détection fournissent des signaux de détection, représentatifs du mouvement de l'élément mobile 3 par rapport à l'élément fixe 4, à la boucle de réaction qui est connectée à l'entrée d'excitation du résonateur 1.

Les conditions d'oscillation sont définies classiquement par les conditions de Barkhausen. Il en résulte que le produit de la fonction de transfert H du résonateur par la fonction de transfert G du circuit électronique qui lui est associé doit avoir un gain supérieur ou égal à 1 et la différence de phase entre les signaux provenant du résonateur 1 et de la boucle de réaction doit être égale à $2.k. \pi$ avec k entier, à la fréquence de résonance.

La fonction de transfert H du résonateur 1 tient compte des caractéristiques mécaniques du résonateur 1 ainsi que de la fonction de transfert des moyens d'excitation. La fonction de transfert H du résonateur 1 est donc fonction de la masse, de la raideur, du coefficient d'amortissement, c'est-à-dire des paramètres géométriques du résonateur et de ses conditions d'encastrement.

La fonction de transfert du circuit associé correspond à la fonction de transfert de la boucle de réaction et des moyens de détection. Si les moyens de détection et d'excitation sont considérés comme des gains K, les conditions de Barkhausen peuvent être redéfinies de la manière suivante :

- il suffit que la boucle de réaction réalise un déphasage égale à $\pi/2$ entre le signal qui rentre dans la boucle de réaction et le signal qui sort de la boucle de réaction et que 2
- le module du circuit associé soit égal à la formule

$$\left\| G(j\omega_0) \right\| = \frac{m_{eff}\omega_0^2}{K_{détect}.K_{excit}.Q}$$

dans laquelle :

$m_{eff}$ est la masse effective du résonateur,
$\omega_0$ est la fréquence de résonance,
$K_{détect}$ est le gain des moyens de détection,
$K_{excit}$ est le gain des moyens d'excitation,
Q est le facteur de qualité.

Il en résulte que pour former un oscillateur, la boucle de réaction doit comporter des dispositifs qui sont en mesure de réaliser le déphasage ci-dessus et d'assurer un gain suffisant pour obtenir des oscillations auto-entretenues.

Ces conditions peuvent être obtenues en ajoutant à la boucle de réaction, un premier 6 et un second 7 transistors montés en série (figure 2). Le second transistor 7 est un transistor d'amplification qui permet d'amplifier la valeur du courant qui est délivré en sortie du premier transistor 6. La boucle de réaction comporte donc au plus deux transistors connectés en série, c'est-à-dire le premier 6 et le second transistor 7. Dans les exemples suivants, la charge capacitive 5 est intégrée à la boucle de réaction. Dans un mode de réalisation particulier (non représenté), la charge capacitive est constituée par les pistes d'interconnexion métalliques du circuit intégré dans lequel les premier et second transistors sont réalisés. La boucle de réaction ne comporte donc, au maximum, que deux transistors connectés en série, mais elle peut comporter en plus quelques éléments passifs tels que, par exemple, des résistances et des condensateurs. Dans le mode de réalisation, la boucle de réaction est constituée uniquement par les premier 6 et second 7 transistors.

Dans l'élément résonant, le premier transistor 6 est connecté entre une tension de référence GND et la borne d'excitation E. Un second transistor 7 est connecté en série avec le premier transistor 6 entre la tension de référence GND et la borne d'excitation E. Les premier 6 et second 7 transistors peuvent être indépendamment de type à effet de champ ou bipolaire. Les premier 6 et second 7 transistors peuvent être de même type ou de types différents.

Si le premier transistor 6 est de type à effet de champ, une première électrode de source/drain du premier transistor 6 est connectée à la tension de référence GND. Une seconde électrode de source/drain est connectée à la borne de d'excitation E par l'intermédiaire du second transistor 7.

L'élément de polarisation 2 permet d'imposer le régime de fonctionnement du premier transistor 6 ou des premier 6 et second 7 transistors et d'assurer le déphasage entre le signal sur la borne E et celui sur la borne de détection D. L'élément de polarisation 2 permet encore d'exciter l'élément mobile 3.

Comme illustré aux figures 1 et 2, l'élément mobile 3 peut être polarisé au moyen d'une tension de polarisation Vpol de manière à moduler les caractéristiques d'oscillation du résonateur.

Dans le cas d'une excitation et d'une détection par des moyens de type capacitif, il est avantageux d'utiliser deux électrodes distinctes, c'est-à-dire deux éléments fixes 4 et 8, disposées de part et d'autre de l'élément mobile 3. Une des électrodes réalise l'excitation de l'élément mobile 3 et l'autre électrode réalise la détection du mouvement de l'élément mobile 3. De cette manière, les couplages électrostatiques sont fortement réduits entre les deux électrodes. Comme illustré à la figure 3, il est également envisageable d'utiliser un résonateur ne possédant qu'un seul élément fixe 4. Cet élément fixe 4 unique comporte alors les moyens d'excitation tandis que l'élément mobile 3 comporte ou constitue les moyens de détection.

La conductivité du premier transistor 6 est contrôlée par les signaux de détection émis par les moyens de détection. Ainsi, selon la position de l'élément mobile 3 par rapport à l'élément fixe 4, l'amplitude du signal de détection évolue et fait varier le courant électrique circulant entre les deux bornes du premier transistor 6.

Le résonateur 1 peut être à mouvement dans le plan ou à mouvement hors du plan. Le résonateur 1 peut être, par exemple, un résonateur de type poutre encastrée-libre (encastrement simple) ou encastrée-encastrée (encastrement double) ou de tout autre type connu.

L'utilisation d'une boucle de réaction ne comportant qu'au plus deux transistors 6 et 7 est particulièrement avantageuse car elle autorise une intégration de la boucle de réaction au plus près du résonateur 1 ce qui permet de fortement réduire la surface occupée par l'élément résonant. De plus, les capacités parasites sont également fortement réduites, ces capacités sont responsables d'une perte du signal utile et de l'apparition d'un bruit de fond empêchant toute oscillation possible.

Le premier transistor 6 étant situé au plus près du résonateur 1, l'influence des capacités parasites est négligeable au regard de la capacité d'entrée du transistor 6 et de la capacité statique du résonateur 1.

La polarisation du premier transistor 6 est réalisée au moyen de l'élément de polarisation 2 qui est connecté avec le premier 6 ou le second 7 (s'il existe) transistor à la borne d'excitation E.

Dans le mode de réalisation de l'oscillateur, l'excitation et la détection sont de type capacitif. Comme illustré à la figure 1, la boucle de réaction est constituée par le premier transistor 6 dont l'électrode de commande, l'électrode de grille ou de base, est connectée aux moyens de détection, c'est-à-dire à la borne D. De cette manière, les moyens de détection modulent la conductivité du premier transistor 6. Le courant délivré par le premier transistor 6 peut être amplifié ou non pour contrôler la force d'actionnement produite par les moyens d'excitation.

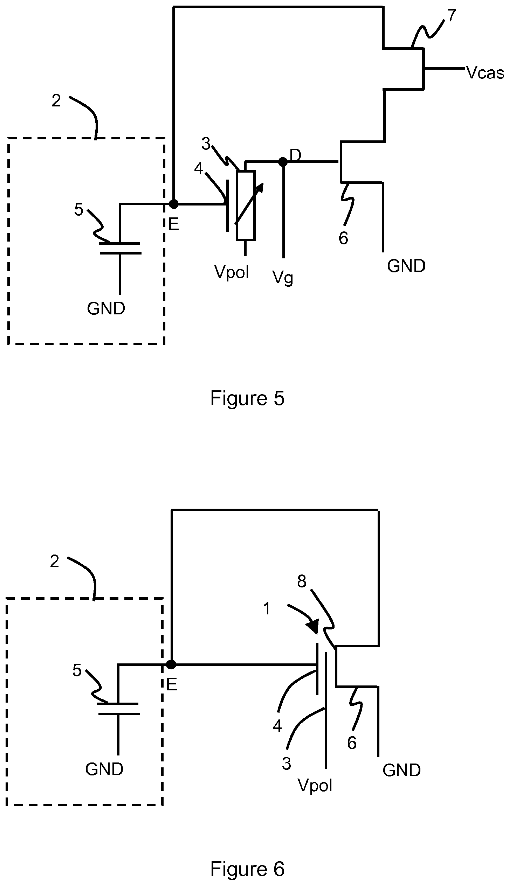

Dans un autre mode de réalisation du résonateur, l'excitation peut être de type capacitive et la détection de type piézorésistive, par exemple par l'utilisation d'un élément mobile de type nanofil. Comme illustré aux figures 4 et 5, le nanofil est connecté entre la tension de polarisation Vpol et la borne de détection D. Le nanofil, jouant le rôle de l'élément mobile 3, est alors actionné par les moyens d'excitation. Comme dans les modes de réalisation précédents, la boucle de réaction est constituée par des premier 6 et second 7 transistors (figure 5).

Comme illustré à la figure 6, le résonateur 1, les moyens d'excitation et les moyens de détection peuvent être constitués par un transistor à grille suspendue. Ce mode de réalisation a notamment été décrit dans un article de Colinet et al. « Measurement of Nano-Displacement Based on In-Plane Suspended-Gate MOSFET Detection Compatible with a Front-End CMOS Process » ISSCC 2008, 18.2 et dans le document WO 2007135064. Dans ce mode de réalisation, le premier transistor 6 est un transistor à effet de champ et sa grille est formée, au moins en partie par l'élément mobile 3 du résonateur 1. Il en résulte que la valeur de la capacité MOS entre le canal et l'élément mobile 3 varie en fonction de la position de l'élément mobile 3 par rapport au canal. Le canal du premier transistor 6 joue alors le rôle de moyen de détection, c'est-à-dire d'élément fixe 4, qui contrôle la conductivité du premier transistor 6.

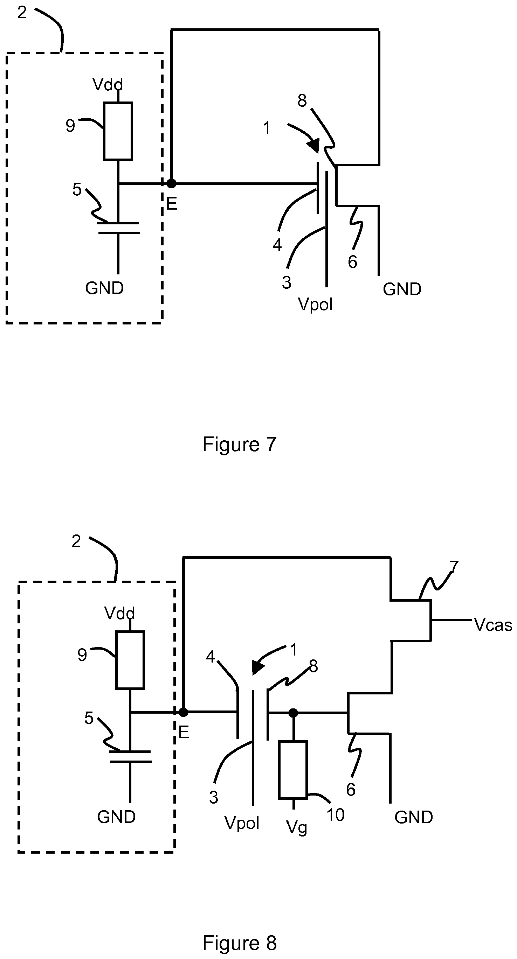

Comme illustré à la figure 7, pour ce type d'oscillateur, l'élément de polarisation 2 peut comporter un condensateur 5 connecté en série avec une résistance de polarisation 9 aux bornes d'une alimentation Vdd. Dans ce cas de figure, la borne commune à la résistance 9 et au condensateur 5 est connectée à la borne d'excitation E.

A titre d'exemple, si le résonateur est de type poutre encastrée-encastrée, sa longueur est égale à $14\mu m$ et sa largeur est égale à $1\mu m$. La poutre a une épaisseur égale à 340nm et la distance entre la poutre et les électrodes de d'excitation et de détection est égale à 100nm. La surface de chaque électrode est égale à $14*0,34\mu m^2$. Ce type de résonateur a typiquement un facteur de qualité égale à 1000 sous vide. La masse effective du résonateur est d'environ $14,8.10^{-11}g$, sa raideur effective est égale à 100,9N/m. La fréquence de résonance du résonateur est égale à 4,6MHz.

Dans cet exemple, illustré à la figure 8, l'élément de polarisation 2 est constitué par une résistance de polarisation 9 connectée entre une tension d'alimentation Vdd et la borne d'excitation E et par le condensateur 5 connecté entre la borne d'excitation E et la tension de référence GND. De plus, le signal de détection émis par les moyens de détection est polarisé au moyen d'une résistance additionnelle 10 sur laquelle la tension additionnelle Vg est appliquée. Les résistances 9 et 10 sont inférieures à 10MOhm, la tension de polarisation appliquée à la borne d'excitation E est égale à 5V. Si les capacités du premier transistor 6 et du condensateur 5 de l'élément de polarisation 2 sont respectivement égales à 10fF et 0,5pF, la boucle de réaction doit avoir une transconductance minimale égale à $29,6\mu S$. Dans cet exemple, un second transistor 7 est inutile car une telle valeur de transconductance est facilement atteignable par un seul transistor.

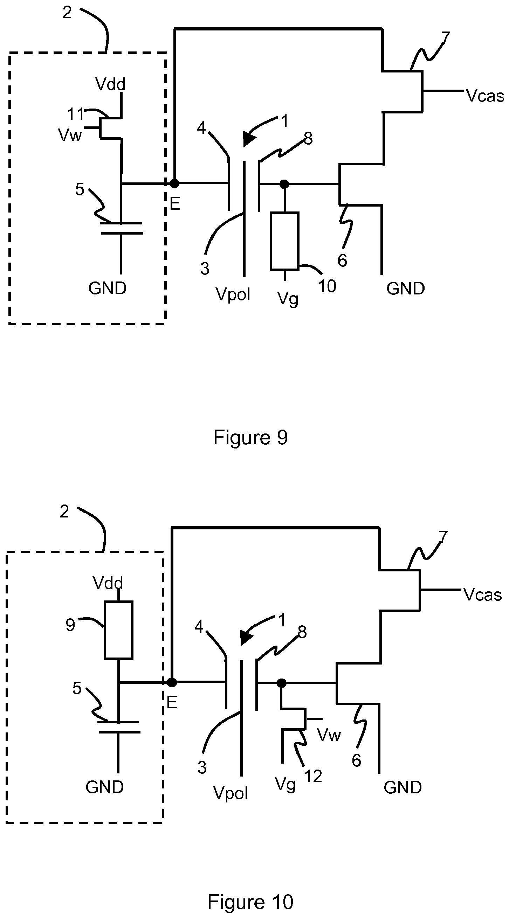

Comme illustré à la figure 9, il est également possible en variante de remplacer la résistance 9 de polarisation par un troisième transistor 11 qui est connecté entre la borne d'excitation E et la tension d'alimentation Vdd. Dans ce cas, la polarisation Vs appliquée sur la borne de commande du troisième transistor permet d'ajuster le courant de polarisation. Le potentiel prédéterminé Vs appliqué sur l'électrode de commande du troisième transistor 11 permet de fixer le régime de fonctionnement du transistor. Le potentiel Vs peut être égal à celui de la borne d'excitation, l'électrode de commande étant alors connectée à la borne d'excitation. Il est également envisageable d'utiliser une source d'alimentation extérieure pour fixer le potentiel prédéterminé Vs.

Dans une autre variante de réalisation, le premier transistor 6 est polarisé au moyen d'une résistance additionnelle 10 qui est connectée entre la borne de détection et l'électrode de commande du premier transistor 6. Il est également possible, dans un mode de réalisation particulier illustré à la figure 10 et qui peut être combiné avec les autres modes de réalisation décrits, de réaliser cette résistance additionnelle au moyen d'un quatrième transistor 12. Le second potentiel prédéterminé Vw qui est appliqué sur l'électrode de commande du quatrième transistor 12 est un potentiel constant. Ce second potentiel prédéterminé Vw est avantageusement égal à celui de l'élément fixe 8 additionnel ou alors un potentiel provenant d'une source extérieure.

Dans encore un autre mode de réalisation, il est également possible de réaliser un oscillateur qui est constitué par un résonateur 1 excité par des moyens capacitif et dont la détection du mouvement est réalisée par des moyens piézorésistifs, par exemple dans un mouvement hors-plan.

Dans ce mode de réalisation, l'électrode d'excitation est avantageusement disposée sous l'élément mobile 3, typiquement une poutre encastrée double. Une jauge piézo-résistive est disposée sur la poutre et quand cette dernière se déforme, la jauge voit sa résistance évoluer. Ainsi, il est possible, par la mesure de la résistance de la jauge de détecter le mouvement de la poutre.

Comme dans les modes de réalisation précédents, la transconductance des transistors 6 et 7 de la boucle de réaction doit tenir compte des gains des moyens de détection de type piézorésistif et des gains des moyens d'excitation. La transconductance doit également tenir compte des bruits de phases associés au résonateur, au premier transistor 6, éventuellement au second transistor 7, et à la jauge piézo-résistive.

A titre d'exemple, si le résonateur est de type poutre encastrée-encastrée, sa longueur est égale à $14\mu m$ et sa largeur est égale à $340\mu m$. La poutre a une épaisseur égale à 160nm et la distance entre la poutre et les électrodes d'excitation et de détection est égale à 100nm. La surface de chaque électrode est égale à $14*0,34\mu m^2$. Ce type de résonateur a typiquement un facteur de qualité égale à 1000 sous vide. La masse effective du résonateur est d'environ $14,8.10^{-11}g$, sa raideur effective est égale à 3,57N/m. La fréquence de résonance du résonateur est égale à 7,8MHz. La jauge est de type AlSi avec un facteur de jauge égale à 2. La longueur de l'électrode d'excitation est égale au quart de la longueur de la poutre. Le gain des moyens de détection est égal à $0,45\ Ohm.nm^{-1}$

L'élément de polarisation 2 est constitué par la résistance de polarisation 9 connectée entre une tension d'alimentation Vdd et la borne d'excitation E et par le condensateur 5 connecté entre la borne d'excitation et la tension de référence GND. De plus, le signal de détection émis par les moyens de détection est polarisé au moyen de la résistance additionnelle 10. Les résistances 9 et 10 sont respectivement inférieures à 10MOhm et égale à 50Ohm, la tension de polarisation appliquée à la borne d'excitation E est égale à 5V. Les capacités du premier transistor 6 et du condensateur 5 de l'élément de polarisation sont respectivement égales à 10fF et 0,5pF. La tension appliquée à la jauge piézo-résistive est égale à 1V. Dans ces conditions, la boucle de réaction doit avoir une transconductance minimale égale à $156\mu S$. Dans cet exemple, un second transistor est inutile car une telle valeur de transconductance est facilement atteignable par un seul transistor.

Dans un autre mode de réalisation, il est également envisageable de réaliser un oscillateur qui comporte un résonateur 1 à actionnement capacitif et à détection piézorésistive. Ce résonateur peut avoir, par exemple, un mouvement dans le plan. Le bras de levier du résonateur 1 est actionné par une force électrostatique et son mouvement d'oscillation induit des contraintes en compression/dilatation dans les jauges placées perpendiculairement à ce bras de levier.

Dans une variante de réalisation du mode précédent, le résonateur 1 est constitué par un nanofil. L'excitation est réalisée par des moyens capacitifs et la détection est réalisée par des moyens piézorésistifs. En effet, les nanofils présentent un effet piézorésistif très important ce qui permet d'obtenir un gain de transduction très élevé des moyens de détection. Ce mode de réalisation est particulièrement avantageux car le gain électronique que doit fournir la boucle de réaction est d'autant plus faible. Le résonateur peut être obtenu en utilisant le nanofil comme résistance variable reliée au premier transistor 6, la variation de résistance étant induite par la déformation du nanofil.

Dans encore un autre mode de réalisation, les moyens d'excitation sont de type thermique alors que les moyens de détection sont de type piézorésistif.

Une telle mise en oeuvre a été proposée par Bargatin et al. « Efficient electrothermal actuation of multiple mode of high-frequency nanomechanical resonators », Applied Physics Letters 90, 2007.

La topologie de l'oscillateur est de type Colpitts, le premier 6 ou les premier 6 et second 7 transistors sont polarisés par l'intermédiaire de l'élément de polarisation 2 capacitif. L'élément de polarisation 2 agit alors comme un amplificateur transimpédance qui est utilisé pour convertir le courant dynamique issu du résonateur 1 en une tension appropriée sur la borne d'excitation E.

Une tension d'amplification Vcas est appliquée sur l'électrode de commande du second transistor 7 de manière à pouvoir ajuster le courant émis à sa sortie et donc la polarisation appliquée sur la borne d'excitation.

Cette architecture constitue un composant actif hybride résonateur/premier transistor co-intégré et dédié à la fonction d'oscillateur. Les différents éléments de l'oscillateur sont alors polarisés pour fixer le gain du premier transistor 6 à effet de champ et le déphasage du signal.

Ce circuit est particulièrement avantageux car la réduction des dimensions du résonateur 1 permet d'obtenir un élément mobile qui est situé à proximité immédiate des éléments fixe de détection et d'excitation. Il en résulte alors que grâce à cette réduction des dimensions, les gains des dispositifs de transduction sont fortement augmentés, particulièrement avec l'utilisation d'un nanofil. De ce fait, la boucle de réaction doit présenter un gain propre qui est typiquement celle de deux transistors en série.

Une boucle de réaction constituée par deux transistors est tout à fait réaliste car la transconductance de la boucle de réaction est fonction des paramètres géométriques du résonateur 1 et des moyens d'excitation et de détection qui lui sont associés.

Par ailleurs, la réalisation sur un même substrat du résonateur, de la boucle de réaction et des moyens de détection permet une meilleure densité d'intégration. Cela permet en particulier de réaliser une matrice de dispositifs résonants sur le substrat. A titre d'exemple, un dispositif résonant avec son circuit électronique de réaction de l'ordre de $100\mu m^2$ peut être réalisé.

## Revendications

1. Dispositif résonant comportant un résonateur (1) électromécanique de taille nanométrique ou micrométrique, comportant un élément mobile (3) et un élément fixe (4), des moyens de détection fournissant des signaux de détection, représentatifs d'un mouvement de l'élément mobile (3) par rapport à l'élément fixe (5), à une boucle de réaction connectée à une entrée d'excitation (E) du résonateur (1), dispositif **caractérisé en ce que** le résonateur (1) étant formé sur un même substrat que les moyens de détection et la boucle de réaction, la boucle de réaction comporte au plus un premier transistor (6) et un second (7) transistor connectés en série entre une tension de référence (GND) et l'entrée d'excitation (E), une charge (5) capacitive étant connectée entre l'entrée d'excitation (E) et la tension de référence (GND), les signaux de détection étant directement appliqués sur l'électrode de commande du premier transistor pour contrôler la conductivité du premier transistor (6).

2. Dispositif selon la revendication 1, **caractérisé en ce qu'**une résistance de polarisation (9) est connectée entre l'entrée d'excitation (E) et une tension d'alimentation (Vdd).

3. Dispositif selon la revendication 1, **caractérisé en ce qu'**un troisième transistor (11) est connecté entre l'entrée d'excitation (E) et une tension d'alimentation (Vdd), une électrode de commande dudit troisième transistor étant polarisée à un potentiel prédéterminé (Vs).

4. Dispositif selon l'une quelconque des revendications 1 à 3, **caractérisé en ce qu'**une résistance additionnelle (10) est connectée entre l'entrée d'excitation (E) et une borne commune entre le premier transistor (6) et les moyens de détection.

5. Dispositif selon l'une quelconque des revendications 1 à 3, **caractérisé en ce qu'**un quatrième transistor est connecté entre la borne d'excitation (E) et une borne commune entre le premier transistor (6) et les moyens de détection, une électrode de commande dudit quatrième transistor (12) étant polarisée à un second potentiel prédéterminé (Vw).

6. Dispositif selon l'une quelconque des revendications 1 à 5, **caractérisé en ce que** les moyens de détections sont de type capacitif.

7. Dispositif selon l'une quelconque des revendications 1 à 5, **caractérisé en ce que** les moyens de détections sont de type piezorésitif.

8. Dispositif selon l'une quelconque des revendications 1 à 7, **caractérisé en ce que** le résonateur (1) est du type à excitation capacitive.

9. Dispositif selon la revendication 7, **caractérisé en ce que** le résonateur (1) est du type à excitation thermoélastique.

10. Dispositif selon les revendications 6 et 8, **caractérisé en ce que** le premier transistor (6) étant de type à grille suspendue ou à grille résistive, les moyens de détection sont constitués par la grille dudit premier transistor (6).

11. Dispositif selon l'une quelconque des revendications 1 à 10, **caractérisé en ce qu'**une tension Vcas est appliquée sur une électrode de commande du second transistor (7).

12. Dispositif selon les revendications 7 et 8, **caractérisé en ce que** les moyens de détection et le premier transistor (6) sont à base de nanofil en matériau semi-conducteur ou métallique.

13. Dispositif selon l'une quelconque des revendications 1 à 12, **caractérisé en ce qu'**il comporte une électrode fixe (8) formant les moyens de détection et une borne de polarisation configurée pour recevoir une tension de additionnelle (Vg) et polariser l'électrode fixe (8) de sorte à décaler le niveau de tension du signal de détection avec la tension additionnelle (Vg).

**Patentansprüche**

1. Resonanzvorrichtung mit einem elektromechanischen Resonator (1) in nanometrischer oder mikrometrischer Größenordnung, der ein bewegliches Element (3) und ein feststehendes Element (4) enthält, wobei Messmittel Messsignale, welche eine Bewegung des beweglichen Elements (3) gegenüber dem feststehenden Element (4) darstellen, an eine Reaktionsschleife abgeben, die mit einem Steuereingang (E) des Resonators (1) verbunden ist,

   **dadurch gekennzeichnet,**
   **dass** bei dem auf einem und dem selben Substrat wie die Messmittel und die Reaktionsschleife gebildeten Resonator (1) die Reaktionsschleife höchstens einen ersten Transistor (6) und einen zweiten Transistor (7) enthält, welche in Reihe zwischen einer Referenzspannung (GND) und dem Steuereingang (E) geschaltet sind, wobei eine kapazitive Ladung (5) zwischen dem Steuereingang (E) und der Referenzspannung (GND) geschaltet ist, wobei die Messsignale direkt an die Steuerelektrode des ersten Transistors abgegeben werden, um die spezifische elektrische Leitfähigkeit des ersten Transistors (6) zu kontrollieren.

2. Vorrichtung nach Anspruch 1,

   **dadurch gekennzeichnet,**
   **dass** ein Polarisationswiderstand (9) zwischen dem Steuereingang (E) und einer Versorgungsspannung (Vdd) geschaltet ist.

3. Vorrichtung nach Anspruch 1,

   **dadurch gekennzeichnet,**
   **dass** ein dritter Transistor (11) zwischen dem Steuereingang (E) und einer Versorgungsspannung (Vdd) geschaltet ist, wobei eine Steuerelektrode dieses dritten Transistors auf ein vorab bestimmtes Potential (Vs) polarisiert ist.

4. Vorrichtung nach einem der Ansprüche 1 bis 3,

   **dadurch gekennzeichnet,**
   **dass** ein zusätzlicher Widerstand (10) zwischen dem Steuereingang (E) und einer gemeinsamen Klemme zwischen dem ersten Transistor (6) und den Messmitteln geschaltet ist.

5. Vorrichtung nach einem der Ansprüche 1 bis 3,

   **dadurch gekennzeichnet,**
   **dass** ein vierter Transistor zwischen dem Steuereingang (E) und einer gemeinsamen Klemme zwischen dem ersten Transistor (6) und den Messmitteln geschaltet ist, wobei eine Steuerelektrode dieses vierten Transistors (12) auf ein zweites vorab bestimmtes Potential (Vw) polarisiert ist.

6. Vorrichtung nach einem der Ansprüche 1 bis 5,

   **dadurch gekennzeichnet,**
   **dass** die Messmittel vom kapazitiven Typ sind.

7. Vorrichtung nach einem der Ansprüche 1 bis 5,

   **dadurch gekennzeichnet,**
   **dass** die Messmittel vom piezoresistiven Typ sind.

**8.** Vorrichtung nach einem der Ansprüche 1 bis 7,

> **dadurch gekennzeichnet,**
> **dass** der Resonator (1) ein Resonator mit kapazitiver Erregung ist.

**9.** Vorrichtung nach Anspruch 7,

> **dadurch gekennzeichnet,**
> **dass** der Resonator (1) ein Resonator mit thermoelastischer Erregung ist.

**10.** Vorrichtung nach einem der Ansprüche 6 und 8,

> **dadurch gekennzeichnet,**
> **dass** bei einem ersten Transistor (6), der als Transistor mit aufgehängtem Gitter oder mit resistivem Gitter ausgeführt ist, die Messmittel von dem Gitter dieses ersten Transistors (6) gebildet werden.

**11.** Vorrichtung nach einem der Ansprüche 1 bis 10,

> **dadurch gekennzeichnet,**
> **dass** eine Spannung Vcas an eine Steuerelektrode des zweiten Transistors (7) angelegt wird.

**12.** Vorrichtung nach einem der Ansprüche 7 und 8,

> **dadurch gekennzeichnet,**
> **dass** die Messmittel und der erste Transistor (6) auf Basis von Nanofaser aus Halbleiter- oder Metall-Werkstoff bestehen.

**13.** Vorrichtung nach einem der Ansprüche 1 bis 12,

> **dadurch gekennzeichnet,**
> **dass** sie eine feststehende Elektrode (8) enthält, die die Messmittel bildet, sowie eine Polarisierungsklemme enthält, die dazu konfiguriert ist, eine Zusatzspannung (Vg) zu empfangen und die feststehende Elektrode (8) dergestalt zu polarisieren, dass der Spannungspegel des Messsignals um die Zusatzspannung (Vg) verschoben wird.

## Claims

**1.** A resonant device comprising an electromechanical resonator (1) of nanometric or micrometric size comprising a mobile element (3) and a fixed element (4), detection means providing detection signals representative of movement of the mobile element (3) with respect to the fixed element (5) to a feedback loop connected to an excitation input (E) of the resonator (1), device **characterized in that** the resonator (1) being formed on the same substrate as the detection means and feedback loop, the feedback loop comprises at most a first transistor (6) and a second transistor (7) connected in series between a reference voltage (GND) and the excitation input (E), a capacitive load (5) being connected between the excitation input (E) and reference voltage (GND), the detection signal being directly applied on the command electrode of the first transistor for controlling the conductivity of the first transistor (6).

**2.** Device according to claim 1, **characterized in that** a bias resistor (9) is connected between the excitation input (E) and a supply voltage (Vdd).

**3.** Device according to claim 1, **characterized in that** a third transistor (11) is connected between the excitation input (E) and a supply voltage (Vdd), a control electrode of said third transistor being biased to a preset voltage (Vs).

**4.** Device according to any one of claims 1 to 3, **characterized in that** an additional resistor (10) is connected between the excitation input (E) and a common terminal between the first transistor (6) and the detection means.

**5.** Device according to any one of claims 1 to 3, **characterized in that** a fourth transistor is connected between the excitation input (E) and a common terminal between the first transistor (6) and the detection means, a control electrode of said fourth transistor (12) being biased to a second preset voltage (Vw).

**6.** Device according to any one of claims 1 to 5, **characterized in that** the detection means are of capacitive type.

**7.** Device according to any one of claims 1 to 5, **characterized in that** the detection means are of piezoresistive type.

**8.** Device according to any one of claims 1 to 7, **characterized in that** the resonator (1) is of the capacitive excitation type.

**9.** Device according to claim 7, **characterized in that** the resonator (1) is of the thermoelastic excitation type.

**10.** Device according to claims 6 and 8, **characterized in that** the first transistor (6) is of the suspended gate type or resistive gate type, the detection means are formed by the gate of said first transistor (6).

**11.** Device according to any one of claims 1 to 10, **characterized in that** a voltage Vcas is applied on a control electrode of the second transistor (7).

**EP 2 256 921 B1**

**12.** Device according to claims 7 and 8, **characterized in that** the detection means and the first transistor (6) are formed by a nanowire made from semiconductor or metallic material.

**13.** Device according to any one of claims 1 to 12, **characterized in that** it comprises a fixed electrode (8) forming the detection means and a polarisation terminal configured to receive an additional voltage (Vg) and to polarize the fixed electrode (8) so as to shift the voltage level from the detection signal with the additional voltage (Vg).

Figure 1

Figure 2

Figure 3

Figure 4

Figure 5

Figure 6

Figure 7

Figure 8

Figure 9

Figure 10

**EP 2 256 921 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2007135064 A

**Littérature non-brevet citée dans la description**

- **FENG et al.** A self-sustaining ultrahigh-frequency nanoelectromechanical oscillator. *nature nanotechnology,* Juin 2008, vol. 3
- **VERD et al.** Monolithic CMOS MEMS Oscillator Circuit for Sensing in the Attogram Range. *IEEE Electron Device Letters,* Février 2008, vol. 29 (2
- **COLINET et al.** Measurement of Nano-Displacement Based on In-Plane Suspended-Gate MOSFET Detection Compatible with a Front-End CMOS Process. *ISSCC,* 2008, vol. 18.2
- **BARGATIN et al.** Efficient electrothermal actuation of multiple mode of high-frequency nanomechanical resonators. *Applied Physics Letters,* 2007, vol. 90